# EUROPÄISCHE PATENTANMELDUNG

(11) **EP 1 324 492 A1**
(43) Veröffentlichungstag der Anmeldung: **02.07.2003**
(21) Anmeldenummer: 01130151.2
(22) Anmeldetag: 19.12.2001
(51) Int. Cl.: H03K 17/16

(54) **Halbleiterschalteranordnung und Verfahren zur Ansteuerung einer Halbleiterschalteranordnung**

(71) Anmelder: ZF Sachs AG, 97424 Schweinfurt (DE)
(72) Erfinder: Karg, Erich, Dipl.-Ing., 97799 Zeitlofs (DE)

(57) **Zusammenfassung**

Eine Halbleiterschalteranordnung, insbesondere Leistungs-Halbleiterschalteranordnung, wie z.B. IGBT, umfasst einen Ansteueranschluss (14), durch dessen Ansteuerung ein Stromfluss durch die Halbleiterschalteranordnung (10) einstellbar ist, ferner umfassend eine Rückkoppelanordnung (24) zum Bereitstellen einer bei nicht leitend Schalten der Halbleiterschalteranordnung (10) in einem zu schaltenden Kreis sich aufbauenden Spannung oder einer damit in Zusammenhang stehenden Größe als Rückkoppelgröße.

## Beschreibung

Die vorliegende Erfindung betrifft eine Halbleiterschalteranordnung bzw. ein Verfahren zum Ansteuern einer derartigen Halbleiterschalteranordnung, insbesondere Leistungs-Halbleiterschalteranordnung, wie z.B. IGBT (Insulated Gate Bipolar Transistor) oder MOSFET (Metal Oxide Semiconductor Field Effect Transistor).

Halbleiterschalteranordnungen, die z.B. Feldeffekttransistoren, diese enthaltende IGBTs, grundsätzlich jedoch auch Bipolar-Transistoren aufweisen, werden häufig bei getaktet betriebenen Leistungsendstufen eingesetzt. Durch periodisches bzw. intermittierendes Ein- und Ausschalten kann durch Pulsweitmodulation eine mittlere anliegende Spannung bzw. auch ein mittlerer Strom, welcher über eine derartige Halbleiterschalteranordnung dann zu dem zu versorgenden System fließt, eingestellt werden. Die zu schaltenden Kreise sind im Allgemeinen derart aufgebaut, dass die Induktivität der versorgenden Quelle beispielsweise durch Vorschalten von Leistungskondensatoren vor die Halbleiterschalter minimiert wird. Restinduktivitäten bleiben jedoch unvermeidbar erhalten, wobei diese Restinduktivitäten sich im Wesentlichen zusammensetzen aus der inneren Induktivität der Leistungskondensatoren, der Halbleiterschalter und der Verbindungsleitungen. Beim Übergang in den nicht leitenden Zustand wird durch die in der Restinduktivität gespeicherte Energie eine Überspannung erzeugt, die umgekehrt proportional zur zeitlichen Dauer des Schaltvorgangs ist. Je schneller der Übergang in den nicht leitenden Zustand ist, desto höher ist in dieser Phase die Überspannung. Kürzere Schaltzeiten haben somit höhere Überspannungen zur Folge. Es besteht dabei grundsätzlich die Gefahr, dass die auf Grund der vorhandenen Restinduktivitäten sich bei Übergang in den nicht leitenden Zustand aufbauende Spannung bzw. Überspannung zu groß wird und beispielsweise bei Erreichen der Durchbruchspannung zu Beschädigungen des Systems führt.

Es ist die Aufgabe der vorliegenden Erfindung, ein Verfahren zum Ansteuern einer Halbleiterschalteranordnung bzw. eine Halbleiterschalteranordnung bereitzustellen, welche bei Übergang in den nicht leitenden Zustand die Gefahr einer Beeinträchtigung durch zu hohe Spannungen mindern.

Gemäß einem ersten Aspekt der vorliegenden Erfindung wird diese Aufgabe gelöst durch ein Verfahren zum Ansteuern einer Halbleiterschalteranordnung, insbesondere einer Leistungs-Halbleiterschalteranordnung, wie z.B. IGBT, wobei beim nicht leitend Schalten der Halbleiterschalteranordnung der Übergang in den nicht leitenden Zustand in Abhängigkeit von einer beim Übergang in den nicht leitenden Zustand in einem zu schaltenden Kreis sich aufbauenden Spannung vorgenommen wird.

Erfindungsgemäß wird die an sich kritische Größe, also die beim Übergang in den nicht leitenden Zustand sich aufbauende Spannung dazu verwendet, um in Rückkopplung den Schaltvorgang so durchzuführen, dass Einfluss auf diese Größe genommen wird und somit dafür gesorgt wird, dass diese einen bestimmten Wert nicht überschreiten kann. Es wird damit also Einfluss auf den zeitlichen Ablauf eines Abschaltvorgangs genommen, so dass zwar unter Akzeptanz einer längeren Schaltzeit die Gefahr des Erreichens der Durchbruchspannung einer derartigen Halbleiterschalteranordnung beseitigt werden kann.

Beispielsweise kann vorgesehen sein, dass die Spannung oder eine damit in Zusammenhang stehende Größe als Rückkoppelgröße in eine Ansteuerschaltung für die Halbleiterschalteranordnung eingegeben wird. Alternativ ist es selbstverständlich möglich, dass die Spannung oder eine damit in Zusammenhang stehende Größe als Rückkoppelgröße an einen Ansteueranschluss der Halbleiterschalteranordnung angelegt wird.

Da es grundsätzlich das Ziel beim Schalten derartiger Halbleiterschalteranordnungen ist, die Schaltvorgänge, so fern akzeptierbar, so schnell als möglich durchzuführen, wird gemäß einem weiteren vorteilhaften Aspekt der vorliegenden Erfindung vorgeschlagen, dass die Spannung oder eine damit in Zusammenhang stehende Größe nur dann als Rückkoppelgröße verwendet wird, wenn die Spannung bzw. die damit in Zusammenhang stehende Größe einen vorbestimmten Grenzwert übersteigt.

Zum Erreichen möglichst kurzer Schaltzeiten kann des Weiteren vorgesehen sein, dass der Übergang in den nicht leitenden Zustand derart vorgenommen wird, dass die Spannung im Bereich, jedoch unter einer Durchbruchspannung der Halbleiterschalteranordnung eingestellt wird.

Gemäß einem weiteren Aspekt der vorliegenden Erfindung wird die voranstehende Aufgabe gelöst durch eine Halbleiterschalteranordnung, insbesondere Leistungs-Halbleiterschalteranordnung, wie z.B. IGBT, umfassend einen Ansteueranschluss, durch dessen Ansteuerung ein Stromfluss durch die Halbleiterschalteranordnung einstellbar ist, ferner umfassend eine Rückkoppelanordnung zum Bereitstellen einer beim nicht leitend Schalten der Halbleiterschalteranordnung in einem zu schaltenden Kreis sich aufbauenden Spannung oder einer damit in Zusammenhang stehenden Größe als Rückkoppelgröße.

Dabei kann beispielsweise vorgesehen sein, dass die Halbleiterschalteranordnung einen Transistorschalter umfasst, dass der Ansteueranschluss ein Gate-Anschluss oder ein Basis-Anschluss ist und dass die Spannung eine Drain-Source-Spannung oder eine Kollektor-Emitter-Spannung oder eine damit in Zusammenhang stehende Größe ist.

Die Rückkoppelanordnung kann eine Kondensatoranordnung sowie in Reihe dazu eine Zenerdiodenanordnung aufweisen, wobei dann vorzugsweise vorgesehen ist, dass eine Zenerspannung der Zenerdiodenanordnung im Bereich einer Durchbruchspannung der Halbleiterschalteranordnung liegt, jedoch kleiner ist als diese. Es kann auf diese Art und Weise erlangt werden, dass die Rückkoppelgröße überhaupt nur dann Einfluss erlangen kann, wenn ein durch die Zenerspannung der Zenerdiodenanordnung vorgegebener Grenzwert überschritten oder erreicht ist.

Hier kann beispielsweise vorgesehen sein, dass die Zenerspannung im Bereich von 80% bis 90% der Durchbruchspannung liegt. Auf diese Art und Weise wird bei ausreichendem Abstand zur Durchbruchspannung ein gleichwohl schnelles Abschalten ermöglicht.

Beispielsweise kann weiter vorgesehen sein, dass die Rückkoppelanordnung die Spannung oder die damit in Zusammenhang stehende Größe in eine Ansteuerschaltung für den Ansteueranschluss eingibt. Alternativ ist es möglich, dass die Rückkoppelanordnung die Spannung oder die damit in Zusammenhang stehende Größe an den Ansteueranschluss anlegt.

Die vorliegende Erfindung wird nachfolgend mit Bezug auf die beiliegenden Zeichnungen detailliert beschrieben. Es zeigt:
- Fig. 1: eine prinzipielle Darstellung einer Halbleiterschalteranordnung gemäß der vorliegenden Erfindung;
- Fig. 2: eine der Fig. 1 entsprechende Ansicht einer abgewandelten Ausgestaltungsform.

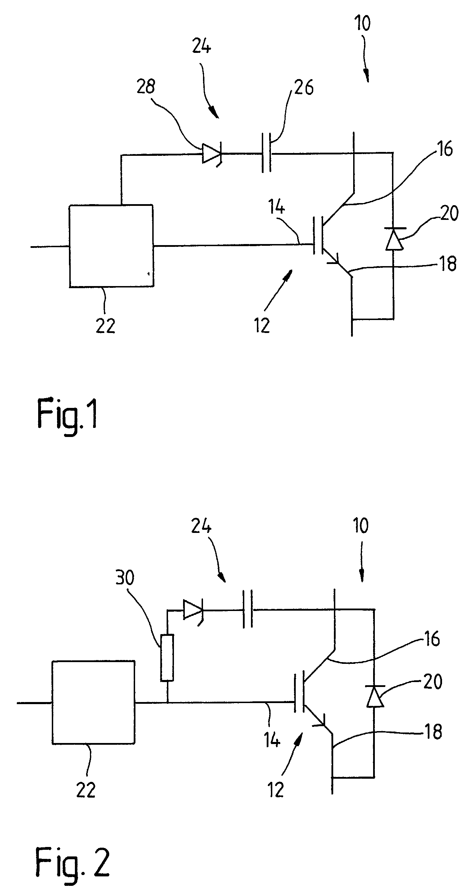

In Fig. 1 ist eine allgemein mit 10 bezeichnete Halbleiterschalteranordnung dargestellt. Diese umfasst einen IGBT (Insulated Gate Bipolar Transistor) 12. Es sei hier darauf hingewiesen, dass die Prinzipien der vorliegenden Erfindung selbstverständlich auch bei anderen Halbleiterschaltern, wie z.B. Bipolar Transistoren, reinen Feldeffekttransistoren und dgl., zur Anwendung kommen kann. Durch Ansteuerung eines Gate-Anschlusses 14 kann in an sich bekannter Weise der Stromfluss zwischen dem Kollektor-Anschluss 16 und dem Emitter-Anschluss 18 bei zwischen diesen Anschlüssen anliegender Spannung eingestellt werden. Dem Schalterelement 12 ist eine Freilaufdiode 20 parallel geschaltet. Der Gate-Anschluss 14 steht unter Ansteuerung einer Ansteuerschaltung 22, die zum leitend Schalten bzw. nicht leitend Schalten das am Gate-Anschluss 14 anliegende Potential verändert.

Durch die in dem zu schaltenden Stromkreis vorhandenen Restinduktivitäten wird bei Durchführen von Abschaltvorgängen, also beim Übergang in einen nicht leitenden Zustand, die Restenergie in Form von Verlustleistung abgebaut. Diese Verlustleistung wird durch eine der Leistung entsprechende Überspannung bemerkbar, deren Größe, ebenso wie die Größe der Verlustleistung, umgekehrt proportional zu der Abschaltzeitdauer ist. Bei sehr schnellem Übergang in den nicht leitenden Zustand kann also die über das Schalterelement 12 aufgebaute Spannung sehr hoch werden und sogar die Durchbruchspannung übersteigen. Gemäß der vorliegenden Erfindung wird diesem Problem dadurch begegnet, dass über eine allgemein mit 24 bezeichnete Rückkoppelanordnung diese beim Übergang in den nicht leitenden Zustand aufgebaute Spannung bzw. Überspannung als Rückkoppelgröße herangezogen wird, um den zeitlichen Verlauf des Abschaltvorgangs einzustellen. Diese Kollektor-Emitter-Spannung wird in der in der Fig. 1 dargestellten Ausgestaltungsform über einen oder mehrere Kondensatoren 26 und eine oder mehrere in Serie geschaltete Zenerdioden 28 in abgeschwächter Form in die Ansteuerschaltung 22 eingegeben. Dabei wird die Zenerspannung der Zenerdiode 28 bzw. die durch Serienschaltung mehrerer Zenerdioden 28 sich durch Summation ergebende Zenerspannung derart eingestellt, dass sie unter der Durchbruchspannung des Schalterelements 12 liegt. Liegt diese Durchbruchspannung beispielsweise im Bereich von 600V, so kann die Zenerspannung derart eingestellt werden, dass sie bei etwa 500V liegt. D.h. erst dann, wenn die Kollektor-Emitter-Spannung diesen Wert von etwa 500V erreicht, wird die Zenerdiode 28 leitend und ermöglicht das Eingeben der Überspannung bzw. einer damit in Zusammenhang stehenden Größe in die Ansteuerschaltung 22. Diese steuert daraufhin den Gate-Anschluss 14 derart an, dass beispielsweise ein weiteres Ansteigen oder übermäßiges Ansteigen der Kollektor-Emitter-Spannung verhindert wird. Vorzugsweise wird derart vorgegangen, dass die bei einem Abschaltvorgang sich aufbauende Kollektor-Emitter-Spannung möglichst nahe an der Durchbruchspannung liegt. Auf diese Art und Weise wird einerseits gewährleistet, dass die Durchbruchspannung nicht erreicht oder überschritten wird, andererseits jedoch der Schaltvorgang so schnell als möglich durchgeführt wird. Bei dieser erfindungsgemäßen Vorgehensweise wird die gespeicherte bzw. bei Durchführung eines Abschaltvorgangs frei werdende Energie im Schalterelement 12 selbst abgebaut. Da dieses im Allgemeinen leistungsmäßig stark beaufschlagte Bauteil sehr gut gekühlt ist, beispielsweise an einen Kühlkörper angekoppelt ist, kann die bei Durchführung des Abschaltvorgangs dann in Form von Wärmeenergie frei werdende Energie abgeführt werden, ohne die anderen Elektronikkomponenten übermäßig zu erwärmen.

Bei der in Fig. 2 dargestellten Ausgestaltungsvariante wird die auf der Kollektor-Emitter-Spannung basierende Rückkoppelgröße über die Rückkoppelanordnung 24, welche wie im Fall der Fig. 1 einen oder mehrere Kondensatoren 26 sowie eine oder mehrere Zenerdioden 28 aufweist, über einen Widerstand 30 direkt an den Gate-Anschluss 14 angelegt und somit als Rückkoppelgröße verwendet.

Durch die vorliegende Erfindung wird in zuverlässiger Weise bei Durchführung möglichst schneller Schaltvorgänge unter Berücksichtigung der bei einem bestimmten Halbleiterschalterelement zulässigen Durchbruchspannung die Gefahr einer zu groß werdenden durch Restinduktivitäten und Stromfluss erzeugten Spannung vermieden. Wie bereits ausgeführt, kann diese Vorgehensweise unabhängig davon durchgeführt werden, welches Halbleiterschalterelement bzw. welcher Typ von Transistoren, eingesetzt wird. Des Weiteren sei darauf hingewiesen, dass an Stelle der in den Figuren 1 und 2 erkennbaren passive Bauteile aufweisenden Rückkoppelanordnungen selbstverständlich die Rückkopplung auch über aktive Bauteile, wie z.B. Transistoren, ICs und dgl. erfolgen kann. Bei allen diesen technischen Ausführungsvarianten kommt das erfindungsgemäße Prinzip zu tragen, dass die an sich kritische Größe, also beispielsweise die Kollektor-Emitter-Spannung bzw. die Drain-Source-Spannung, überwacht bzw. als Rückkoppelgröße herangezogen wird, um den zeitlichen Ablauf des Schaltvorgangs so einzustellen, dass diese beobachtete Größe einen bestimmten Wert nicht erreicht oder überschreitet.

## Patentansprüche

1. Verfahren zum Ansteuern einer Halbleiterschalteranordnung, insbesondere einer Leistungs-Halbleiterschalteranordnung, wie z.B. IGBT, wobei beim nicht leitend Schalten der Halbleiterschalteranordnung (10) der Übergang in den nicht leitenden Zustand in Abhängigkeit von einer beim Übergang in den nicht leitenden Zustand in einem zu schaltenden Kreis sich aufbauenden Spannung vorgenommen wird.

2. Verfahren nach Anspruch 1,
**dadurch gekennzeichnet, dass** die Spannung oder eine damit in Zusammenhang stehende Größe als Rückkoppelgröße in eine Ansteuerschaltung (22) für die Halbleiterschalteranordnung (10) eingegeben wird.

3. Verfahren nach Anspruch 1,
**dadurch gekennzeichnet, dass** die Spannung oder eine damit in Zusammenhang stehende Größe als Rückkoppelgröße an einen Ansteueranschluss (14) der Halbleiterschalteranordnung (10) angelegt wird.

4. Verfahren nach einem der Ansprüche 1 bis 3,
**dadurch gekennzeichnet, dass** die Spannung oder eine damit in Zusammenhang stehende Größe nur dann als Rückkoppelgröße verwendet wird, wenn die Spannung bzw. die damit in Zusammenhang stehende Größe einen vorbestimmten Grenzwert übersteigt.

5. Verfahren nach einem der Ansprüche 1 bis 4,
1 **dadurch gekennzeichnet, dass** der Übergang in den nicht leitenden Zustand derart vorgenommen wird, dass die Spannung im Bereich, jedoch unter einer Durchbruchspannung der Halbleiterschalteranordnung (10) eingestellt wird.

6. Halbleiterschalteranordnung,insbesondereLeistungs-Halbleiterschalteranordnung, wie z.B. IGBT, umfassend einen Ansteueranschluss (14), durch dessen Ansteuerung ein Stromfluss durch die Halbleiterschalteranordnung (10) einstellbar ist, ferner umfassend eine Rückkoppelanordnung (24) zum Bereitstellen einer bei nicht leitend Schalten der Halbleiterschalteranordnung (10) in einem zu schaltenden Kreis sich aufbauenden Spannung oder einer damit in Zusammenhang stehenden Größe als Rückkoppelgröße.

7. Halbleiterschalteranordnung nach Anspruch 6,
**dadurch gekennzeichnet, dass** die Halbleiterschalteranordnung (10) einen Transistorschalter (12) umfasst, dass der Ansteueranschluss (14) ein Gate-Anschluss (14) oder ein Basis-Anschluss ist und dass die Spannung eine Drain-Source-Spannung oder eine Kollektor-Emitter-Spannung oder eine damit in Zusammenhang stehende Größe ist.

8. Halbleiterschalteranordnung nach Anspruch 6 oder 7,
**dadurch gekennzeichnet, dass** die Rückkopplungsanordnung (24) eine Kondensatoranordnung (26) sowie eine Zenerdiodenanordnung (28) in Reihe dazu umfasst.

9. Halbleiterschalteranordnung nach Anspruch 8,
**dadurch gekennzeichnet, dass** eine Zenerspannung der Zenerdiodenanordnung (28) im Bereich einer Durchbruchspannung der Halbleiterschalteranordnung (10) liegt, jedoch kleiner ist als diese.

10. Halbleiterschalteranordnung nach Anspruch 9,
**dadurch gekennzeichnet, dass** die Zenerspannung im Bereich von 80% bis 90% der Durchbruchspannung liegt.

11. Halbleiterschalteranordnung nach einem der Ansprüche 6 bis 10,
**dadurch gekennzeichnet, dass** die Rückkoppelanordnung (24) die Spannung oder die damit in Zusammenhang stehende Größe in eine Ansteuerschaltung (22) für den Ansteueranschluss (14) eingibt.

12. Halbleiterschalteranordnung nach einem der Ansprüche 6 bis 10,
**dadurch gekennzeichnet, dass** die Rückkoppelanordnung (24) die Spannung oder die damit in Zusammenhang stehende Größe an den Ansteueranschluss (14) anlegt.
